# EUROPÄISCHE PATENTSCHRIFT

(11) **EP 0 897 997 B1**
(45) Veröffentlichungstag und Bekanntmachung des Hinweises auf die Patenterteilung: **26.02.2003**
(21) Anmeldenummer: 98115821.5
(22) Anmeldetag: 21.08.1998
(51) Int. Cl.: C23C 16/30, C23C 16/18, C23C 16/02

(54) **Verbundwerkstoff**
Composite material
Matériau composite

(30) Priorität: 21.08.1997 DE 19736449
(43) Veröffentlichungstag der Anmeldung: 24.02.1999
(73) Patentinhaber: GfE Metalle und Materialien GmbH, 90431 Nürnberg (DE)
(72) Erfinder: Breme, Frank, 91341 Röttenbach (DE); Güther, Volker, 90559 Burgthann (DE); Van Osten, Karl-Uwe, 90584 Allersberg (DE)
(74) Vertreter: Freiherr von Wittgenstein, Arved, Dr.

(56) Entgegenhaltungen:
- EP-A- 0 267 679
- CA-A- 1 337 484
- DE-A- 3 905 417
- US-A- 5 290 609

## Beschreibung

Die vorliegende Erfindung betrifft einen Verbundwerkstoff aus einem Kunststoffsubstrat und einer fest haftenden dünnen metallhaltigen Schicht. Die metallhaltige Schicht besteht aus mindestens einem Metall aus der Gruppe bestehend aus Ti, Ta, Nb, Zr und Hf und einem Anteil an mindestens einem der Elemente C, B, N, O. Die Erfindung betrifft weiterhin ein Verfahren zur Herstellung eines solchen Verbundwerkstoffes. Die erfindungsgemäßen Verbundwerkstoffe können insbesondere in der Medizintechnik eingesetzt werden.

Die Verwendung von Kunststoffen in der Medizintechnik wird häufig durch ungenügende Oberflächeneigenschaften eingeschränkt. Dies betrifft insbesondere die Bio- und Blutverträglichkeit von z.B. Gefäßprothesen, Kathetern oder Sensoren. So können trotz großer Anstrengungen bis zum heutigen Zeitpunkt Gefäßprothesen aus Kunststoffen mit einem Durchmesser > 6 mm aufgrund der trotzdem bestehenden Thrombosegefahr nur eingeschränkt verwendet und Gefäßprothesen mit einem Durchmesser von < 6 mm in keinem Fall eingesetzt werden. Bei einem Durchmesser von < 6 mm liegt jedoch der sehr große Anwendungsbereich von künstlichen Herzkranzgefäßen (s. R. Zdrahala: Small Caliber Vascular Grafts, J. of Biomaterials Appl., Vol. 10 No. 4, Apr. 1996, S. 309-329).

Auch beim Einsatz von Kathetern kommt es, obgleich diese meist nur kurz in Kontakt zum Körper stehen, aufgrund der mangelnden Körperverträglichkeit der Kunststoffe in vielen Fällen zu Komplikationen, die eine ernsthafte Gefährdung des Patienten bedeuten können (s. R. Dujardin; Polymerstruktur und Thrombogenität, in Symposium Materialforschung - Neue Werkstoffe, S. 724-749, PLR Jülich 1994). Die Verwendung von Kunststoffen ist jedoch aufgrund ihrer vorteilhaften mechanischen Eigenschaften in vielen Bereichen der Medizintechnik unumgänglich.

Es ist bekannt, daß Materialien auf Basis von Titan, Niob, Tantal, Zirkon oder Hafnium bioverträgliche Eigenschaften aufweisen (s. Clarke E.G. und Hickman J., An investigation into the correlation between the electrical potential of metals and their behaviour in biological fluids, J. Bone Joint Surg., Vol. 35 B (1953) 467). Außerdem wurde die ausgezeichnete Blutverträglichkeit von Titannitrid nachgewiesen (s. Y. Mitamura, Development of a ceramic heart valve, in J. of Biomaterials Applications, Vol. 4, Juli 1989, S. 33-55). Es existiert jedoch bis heute kein Material, das sowohl die vorteilhaften mechanischen Eigenschaften der Kunststoffe, als auch die hervorragenden Verträglichkeitseigenschaften der Verbindungen auf der Basis von Ti, Ta, Nb, Zr und Hf aufweist.

Es ist bekannt, daß durch chemische Gasphasenabscheidung (CVD) die Möglichkeit besteht, auch Substrate mit komplizierter Geometrie, wie sie in der Medizintechnik eingesetzt werden, zu beschichten. Allerdings sind bei den bisher meistens verwendeten anorganischen Ausgangssubstanzen zur Beschichtung mit den in Betracht kommenden Materialien Reaktionstemperaturen von > 600°C notwendig (s. S. Siveram, Chemical Vapor Depostion, Van Nostrand Reinhold, New York 1995). Weiterhin ist bekannt, daß durch den Einsatz von organometallischen oder metallorganischen Ausgangssubstanzen Beschichtungstemperaturen von ca. 300°C verwendet werden können (s. Sugiyama: Low Temperature Deposition of Metal Nitrides by Thermal Decomposition of Organometallic Compounds, J. Electrochem. Soc., Sept. 1975, S. 1545-1549). Außerdem wurde berichtet, daß die Beschichtungstemperaturen durch den Einsatz von Lasern oder durch die Einkopplung eines Niederdruckplasmas deutlich gesenkt werden können. Die niedrigste bekannte Beschichtungstemperatur von den in Frage kommenden Materialien wird mit 150°C in Zusammenhang mit der Abscheidung von Ti(C,N) und Zr(C,N) aus Ti[N(CH₃)₂]₄ bzw. Zr[N(CH₃)₂]₄ durch plasmaaktivierte CVD (PACVD) angegeben, wobei eine gepulste Gleichstromanregungsquelle für die Erzeugung des Plasmas eingesetzt wurde (s. K.-T. Rie et al., Studies on the synthesis of hard coatings by plasma-assisted CVD using metallo-organic compounds, Surface and Coating Technology 74-75 (1995), S.362-368). Diese Beschichtung wurde zum Verschleißschutz auf metallischen Substraten aufgebracht, auf denen eine ausreichende Haftfestigkeit problemlos erreicht werden kann.

Aus der DE-A-195 06 188 ist ein Implantat für den Einsatz im menschlichen Körper bekannt, das aus einem Substrat und einer metallhaltigen Beschichtung besteht. Als Substrat werden zwar Kunststoffe erwähnt, in den Beispielen werden als Substrate jedoch Metalle verwendet. Die Beschichtung kann sowohl mittels CVD als auch mittels PVD (physikalische Gasphasenabscheidung) erfolgen. Bevorzugt wird das PVD-Verfahren, da im einleitenden Teil der DE-A-195 01 188 darauf hingewiesen wird, daß beim CVD-Verfahren eine starke Erhitzung des Substrats erforderlich ist. Im Rahmen der Lehre der DE-A-195 06 188 kommt somit das CVD-Verfahren für die Beschichtung von Kunststoffen nicht in Betracht, da diese bei den erwähnten hohen Temperaturen zerstört würden. Die in der DE-A-195 06 188 beschriebenen PVD-Beschichtungen weisen erhebliche Mängel auf:
- Es ist sehr schwierig bzw. aufwendig (wenn nicht sogar unmöglich) komplizierte Geometrien, wie z.B. bei textilen Implantaten (Gefäßprothesen, Kunststoffnetze zur Behandlung von Leistenbrüchen, etc.) durch PVD zu beschichten. Der Fachmann kennt dieses Phänomen als "Abschattungseffekt".
- Für eine ausreichende Haftung ist meist ein Aufrauhen und/oder eine Zwischenschicht erforderlich (siehe beispielsweise die Ansprüche 12 bis 14 der DE-A-195 06 188).
- Die Schichten sind mehr oder weniger porös, was nachteilig für die Korrosionsbeständigkeit ist. Weiterhin kann es durch die Poren leicht zu einer unerwünschten Adsorption von beispielsweise Blutbestandteilen kommen.

Aus der WO 91/08322 ist ein Verfahren zur chemischen Gasphasenabscheidung von Übergangsmetallnitriden auf verschiedenen Substraten bekannt. Bevorzugte Substrattemperaturen liegen zwischen 200 und 250°C. In Beispiel 6 werden Polyesterplatten als Substrat verwendet, die bei einer Temperatur von 150°C gehalten und mit Titannitrid beschichtet werden. Als Reaktionsgas muß bei diesem Verfahren Ammoniak eingesetzt werden. Die Zugabe des extrem reaktiven Ammoniaks führt jedoch unweigerlich zu unerwünschten Gasreaktionen (siehe: S. Intemann, "Eigenschaften von CVD-Titanverbindungsschichten aus metallorganischen Verbindungen für die Mehrlagenmetallisierung höchst integrierter Bauelemente", Dissertation TU München, 1994), was wiederum zu einem ungleichmäßigen Schichtaufbau und einem sehr ausgeprägten Abschattungseffekt führt, so daß die Vorteile des CVD-Verfahrens gegenüber dem PVD-Verfahren zunichte gemacht werden.

Es ist somit noch kein zufriedenstellendes Verfahren bekannt, mit welchem man mittels CVD Kunststoffe mit metallhaltigen Schichten in zufriedenstellender Weise beschichten kann. Entweder sind die für die Beschichtung erforderlichen Substrattemperaturen zu hoch und führen zu einer Schädigung des Kunststoffsubstrats, oder die bekannten Verfahren führen zu Beschichtungen, die nicht zufriedenstellend sind. Überwiegend bestand in der Fachwelt das Vorurteil, daß Verbundwerkstoffe aus weichen Substraten und harten Schichtmaterialien nicht hergestellt werden können.

So beschreibt A. Bolz in seiner Dissertation, Physikalische Mechanismen der Festkörper-Protein-Wechselwirkung an der Phasengrenze a-SiC:H-Fibrinogen, Universität Erlangen-Nürnberg, 1991, daß eine Beschichtung von weichen Substraten, wie z.B. Kunststoffen, mit harten Schichtmaterialien, wie z.B. SiC, wegen des auftretenden "Federbetteffektes" nicht möglich ist.

Aufgabe der vorliegenden Erfindung ist es, einen Verbundwerkstoff aus einem Kunststoff substrat und einer dünnen, fest haftenden geschlossenen metallhaltigen Schicht auf der Basis von Ti, Ta, Nb, Zr und Hf zur Verfügung zu stellen sowie ein Verfahren zu schaffen, mit dem die Herstellung eines solchen Verbundwerkstoffes gelingt. Es galt dabei ein Beschichtungsverfahren zu entwickeln, das die folgenden Anforderungen erfüllt:
- Keine Beschädigung des Kunststoffsubstrats durch den Beschichtungsvorgang, insbesondere durch zu hohe thermische Belastung.
- Ausreichende Haftfestigkeit der Schicht, trotz der extremen Unterschiede in den Eigenschaften von Schicht und Substrat, wie thermische Ausdehnung und Elastizität.
- Glatte Oberfläche der Schicht zur Minimierung von Wechselwirkungen, wie z.B. Adsorptionsvorgänge von Körperflüssigkeiten.

Die hergestellten Verbundwerkstoffe müssen dabei bioverträgliches Verhalten gegen Weichgewebe, Knochen, Blut, etc., zeigen, eine ausreichend Korrosionsbeständigkeit besitzen und darüber hinaus üblicherweise antithrombogenes Verhalten aufweisen.

Die Aufgabe wird gelöst durch einen Verbundwerkstoff, bestehend aus einem Kunststoffsubstrat und einer dünnen geschlossenen metallhaltigen Schicht, dadurch gekennzeichnet, daß die metallhaltige Schicht duktil ist, fest auf dem Kunststoffsubstrat haftet, eine Dicke von < 2 µm aufweist und aus einer Verbindung der Formel

MₐO_{b}CₓN_{y}B_{z}

besteht, in welcher bedeuten:
- M: ein oder mehrere Metalle aus der Gruppe Ti, Ta, Nb, Zr und Hf,
a = 0,025 bis 0,9
b = 0,025 bis 0,7
x = 0,2 bis 0,9
y = 0 bis 0,7
z = 0 bis 0,7
a + b + x + y + z = 1,
mit der Maßgabe, daß der Wert von a von der Substratoberfläche ausgehend von einem Wert nahe Null zur Schichtoberfläche hin zunimmt und die Kohlenstoffatome an der Basis der Schicht zu mindestens 50 % an anderen Kohlenstoffatomen durch C-C-Bindungen gebunden sind. Zur Schichtoberfläche hin können die Kohlenstoffatome zunehmend bis vollständig an Metallatomen durch M-C-Bindungen gebunden sein oder in C-C-Bindungen vorliegen.

Ein solcher Verbundwerkstoff kann hergestellt werden, indem man
a) das Kunststoffsubstrat reinigt,
b) eine geeignete metallorganische oder organometallische Ausgangsverbindung auswählt,
c) die metallorganische oder organometallische Ausgangsverbindung, sofern sie nicht gasförmig ist, in die Gasphase überführt,
d) die gasförmige metallorganische oder organometallische Verbindung Ausgangsverbindung mit Hilfe eines Trägergases in einen Reaktor befördert, in welchem sich das Kunststoffsubstrat befindet, auf dessen Oberfläche die Ausgangsverbindungen durch chemische Gasphasenabscheidung unter Zersetzung und Reaktion abgeschieden werden, wobei
e) dem Substrat durch Plasmaeinkoppelung und gegebenenfalls direkte Beheizung Energie so zuführt, daß eine Temperatur von 100° nicht überschritten wird, wobei durch die Wirkung des Plasmas ein Kohlensstoff- und Metallgradient in Richtung der Schichtdicke erzielt wird,
f) im Reaktionsraum einen Druck von 0,1 bis < 50 mbar aufrechterhält, und
g) den Verbundstoff anschließend an Luft lagert.

Durch die vorliegende Erfindung gelingt es, trotz der extremen Unterschiede der Eigenschaften zwischen Kunststoffsubstrat und metallhaltiger Beschichtung, haftfeste Schichten aufzubringen, wodurch eine erhebliche Verbesserung der Oberflächeneigenschaften gegenüber den unbeschichteten Kunststoffen verwirklicht werden kann und damit Kunststoffe in der Medizintechnik für beispielsweise Blutgefäße und dergleichen eingesetzt werden können.

Die Haftfestigkeit ist deshalb ein so großes Problem, da sich die für die Beschichtung in Frage kommenden Materialien erheblich in ihren Eigenschaften von den Kunststoffen unterscheiden. Dies sind z.B. der thermische Ausdehnungskoeffizient, der bei den Kunststoffen um ca. den Faktor 100 größer ist, und die Verformbarkeit. Insbesondere durch das unterschiedliche Ausdehnungsverhalten kann es zu erheblichen Spannungen in der Grenzschicht kommen, was letztlich zum Abplatzen der aufgetragenen Schichten führt. Diese Grenzschichtspannungen können durch einen fließenden Übergang in der Zusammensetzung minimiert werden. Dies gelingt durch das erfindungsgemäß entwickelte Beschichtungsverfahren.

Gegenüber den mittels PVD aufgebrachten Schichten, über welche weiter oben im Zusammenhang mit der DE-A-195 06 188 berichtet worden ist, weisen die erfindungsgemäßen Verbundwerkstoffe, deren Schichten durch CVD abgeschieden werden, wesentliche Vorteile auf:
- Die Haftung wird durch C-C-Bindungen an der Basis der Schicht und durch den gradierten Aufbau der Beschichtung erzielt, wodurch ein "sanfter" Übergang vom Kunststöffsubstrat zur keramischen Schicht erreicht wird. Das Vorliegen der C-C-Bindungen an der Basis und der M-C-Bindungen an der Oberfläche der Schicht kann durch XPS-Analysen (XPS = Röntgenstrahlelektronenspektroskopie) ermittelt werden.
- Durch diesen Aufbau ist kein Aufrauhen des Substrats zur Steigerung der Haftfestigkeit notwendig.
- Die Schichten sind extrem glatt (Rₐ = 0,001 µm) und geschlossen. Dadurch ist die Austauschfläche kleiner als bei rauheren und porösen Schichten. Dies führt zu einer besseren Korrosionsbeständigkeit und Bio- und Blutverträglichkeit als bei rauheren und porösen Schichten.

In den Zeichnungen zeigen
- die Figur 1: eine XPS-Analyse der Beschichtung in Abhängigkeit von der Schichttiefe unmittelbar nach der Beschichtung,
- die Figur 2: eine entsprechende Analyse nach zweiwöchiger Lagerung des beschichteten Substrats an Luft, und
- die Figur 3: eine schematische Darstellung des erfindungsgemäßen Beschichtungsverfahrens.

Als Kunststoffsubstrat der erfindungsgemäßen Verbundwerkstoffe eignen sich insbesondere Polyethylenterephthalat (PET), Polyurethan (PUR), Polytetrafluorethylen (PTFE), Polyamid (PA) und Polypropylen (PP), die auch bislang schon zur Herstellung von Gefäßprothesen verwendet worden sind (siehe R. Zdrahala: Small Caliber Vascular Grafts, Part I: State of the Art; Journal of Biomaterials Applications, Vol. 10, April 1996, Seiten 309-329).

Weitere Kunststoffe, die für die vorliegenden Zwecke in Betracht kommen können, sind Polyetheretherketon (PEEK), Polysulfon (PSU), Polybutylenterephthalat (PBT), Polyethersulfon (PES), Polyimid (PI), Polycarbonat (PC), Polyetherimid (PEI), Polyamidimid (PAI) und dergleichen oder auch Silikone. Alle diese Kunststoffe sind bei einer Temperatur von ca. 100°, bei der die Beschichtung mit der metallhaltigen Schicht erfolgt, stabil.

Auf dem Kunststoffsubstrat befindet sich die dünne metallhaltige Schicht, die eine Dicke von < 2 µm besitzt. Vorzugsweise liegt die Schichtdicke innerhalb eines Bereiches von 5 bis 700 nm, insbesondere innerhalb eines Bereiches von 5 bis 500 nm.

Die metallhaltige Schicht besteht aus einer Metallverbindung der Formel

MₐO_{b}CₓN_{y}B_{z}.

M bedeutet ein oder mehrere Metalle aus der Gruppe Ti, Ta, Nb, Zr und Hf.

a bedeutet 0,025 bis 0,9; b bedeutet 0,025 bis 0,7; x bedeutet 0,2 bis 0,90; y bedeutet 0 bis 0,7 und z bedeutet 0 bis 0,7.

a + b + x + y + z betragen zusammen gleich 1.

Je nach verwendetem Trägergas kann in den Schichten ein gewisser Anteil an Wasserstoff vorliegen.

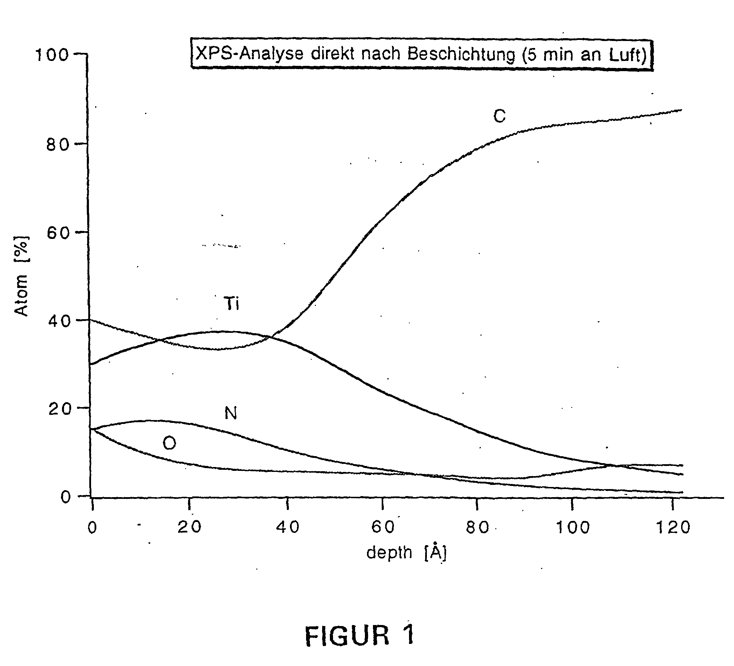

Es gilt weiterhin die Maßgabe, daß der Wert von a von der Substratoberfläche ausgehend von einem Wert nahe 0 zur Schichtoberfläche hin zunimmt. Dies ist für eine gute Haftung der metallhaltigen Schicht einer Substratoberfläche wichtig. Der Kohlenstoffgehalt ist an der Basis der metallhaltigen Schicht, also nahe der Substratoberfläche, besonders hoch. x nimmt in der Regel einen Wert von nahe 0,9 an. Bei zunehmender Schichtdicke verändert sich die Zusammensetzung der metallhaltigen Schicht beträchtlich. Der Anteil an Kohlenstoff nimmt ab, während die Anteile an Metall, gegebenenfalls Stickstoff, Bor und Sauerstoff zunehmen. Die sich mit der Schichtdicke ändernde Zusammensetzung ist in Figur 1 am Beispiel einer titanhaltigen Schicht dargestellt. Wie dieser Schichtaufbau im einzelnen hergestellt werden kann, wird weiter unten beschrieben werden.

Vorzugsweise gilt für die Werte von a, b, x, y und z folgendes:
(i) an der Basis der metallhaltigen Schicht:
   a = 0,025 - 0,1
   b = 0,025 - 0,2
   x = 0,8 - 0,9
   y = 0 - 0,1
   z = 0 - 0,1
(ii) mit zunehmender Dicke der metallhaltigen Schicht wird der Wert von a größer, und
(iii) nahe der Oberfläche der metallhaltigen Schicht:
   a = 0,2 - 0,9
   b = 0,025 - 0,7
   x = 0 - 0,7
   y = 0 - 0,7
   z = 0 - 0,5

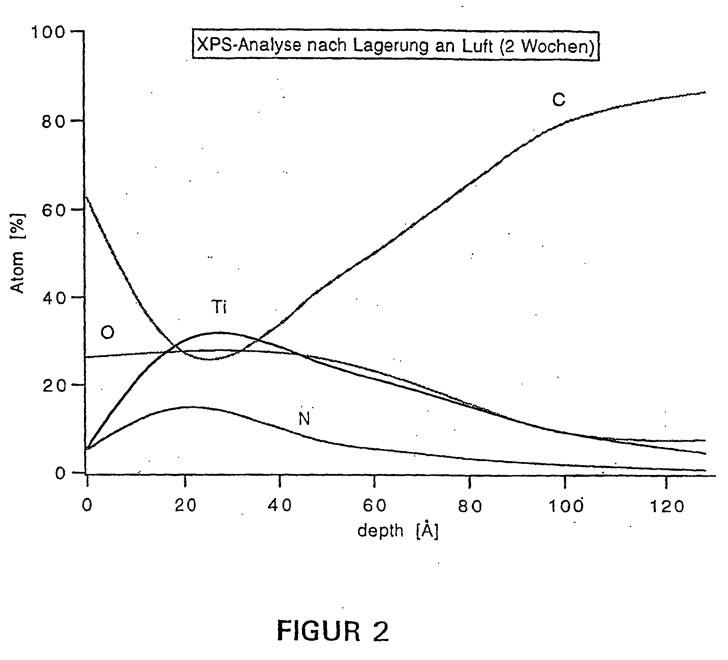

Nach der Lagerung an Luft verändert sich die Zusammensetzung der metallhaltigen Schicht in ihren obersten Bereichen. Kohlenstoff und Sauerstoff nehmen zu, während die Anteile an Metall und Stickstoff leicht abnehmen. Diese Veränderung ist in Figur 2 ebenfalls am Beispiel einer titanhaltigen Schicht dargestellt.

Die Schichtzusammensetzungen der Figuren 1 und 2 wurden durch XPS (X-ray photoelectron spectroscopy) bestimmt. Dabei wurden die Tiefenprofile durch Absputtern der Schichten mit Ar⁺ aufgenommen.

Eines der wenigen bislang bekannten Kriterien für gute Blutverträglichkeit ist neben einer glatten Oberfläche eine Mindestleitfähigkeit von L > 10⁻⁴ (Ohm·cm)⁻¹ (siehe A. Bolz, Physikalische Mechanismen der Festkörper-Protein-Wechselwirkung an der Phasengrenze a-SiC:H-Fibrinogen, Dissertation, Universität Erlangen-Nürnberg, 1991). Erfindungsgemäß sind Leitfähigkeiten der metallhaltigen Schicht unmittelbar nach ihrer Herstellung von L = 2,1 (Ohm·cm)⁻¹ gemessen worden. Nach 3-tägiger Lagerung an Luft betrug L = 0,18 (Ohm·cm)⁻¹.

Rauhigkeitsmessungen der Schichtoberflächen haben ergeben, daß diese außerordentlich glatt sind. Bei den erfindungsgemäßen Schichtoberflächen ist der Rauhigkeitswert Rₐ = 0,001 µm gemessen worden. Im Vergleich dazu liegen die Rauhigkeitswerte der einzigen in der-Literatur beschriebenen CVD-Schichten zur Steigerung der Blutverträglichkeit wesentlich höher, nämlich bei: Rₐ = 0,43 µm und Rₜ = 2,4 µm (siehe I. Dion, TiN-Coating: Surface Characterization and Haemocompatibility, Bio-materials, Vol. 14, Nr. 3, 1993, Seiten 169-176).

Die erfindungsgemäßen Schichten haften außerordentlich fest am Kunststoffsubstrat. Messungen haben Zughaftfestigkeiten von > 6 N/mm² (Versagen des Klebers beim Abzugsversuch) ergeben.

Um eine gute Haftfestigkeit zwischen metallhaltiger Beschichtung und Kunststoffsubstrat zu erreichen, ist es notwendig, das Kunststoffsubstrat vor der Beschichtung von Verunreinigungen zu befreien (beispielsweise von Gleitmittel vom Herstellungsprozeß, von Verunreinigungen vom Verpackungsmaterial etc.). Dies kann beispielsweise durch den Einsatz flüssiger Reinigungsmittel erfolgen, zweckmäßig wird jedoch die Reinigung mit Hilfe eines Niederdruckplasmas durchgeführt (siehe z.B. A. Mann, Plasmamodifikation von Kunststoffoberflächen zur Haftfestigkeitssteigerung von Metallschichten, Dissertation, Universität Stuttgart, 1993). Im Niederdruckplasma werden die Gase angeregt (ionisiert, radikalisiert) und treffen mit zum Teil hoher kinetischer Energie auf das Substrat bzw. auf die Verunreinigung. Dadurch werden die Verunreinigungen abgetragen oder zersetzt und können über die Gasphase abtransportiert werden. Durch dieses Behandlungsverfahren kann es darüber hinaus zu einer Aktivierung der Substratoberfläche kommen, was schließlich zu einer gesteigerten Haftfestigkeit führt.

Als Ausgangsmaterialien für die Herstellung der metallhaltigen Schicht eignen sich zahlreiche metallorganische und organometallische Verbindungen. Bei den Metallen Titan, Zirkonium und Hafnium kommen beispielsweise die folgenden Verbindungsgruppen in Betracht:
- Amidoverbindungen:: z.B. M[N[CH₃]₂]₄, M[N[C₂H₅]₂]₄, M[N(CH₂) (C[CH₃]₂)]₄
- Imidoverbindungen:: z.B. ((N^{t}Bu)M[N(CH₃)₂]₂)₂, ((N^{t}Bu)M[N(C₂H₅)₂]₂)₂
- Verbindungen mit M-C-Bindung:: z.B. M(CH₂^{t}Bu)₄, (C₅H₅)₂MCl₂
mit M = Ti, Zr oder Hf.

Für die Metalle Tantal und Niob kommen die folgenden Verbindungsgruppen in Betracht:
- Amidoverbindungen:: z.B. M[N[CH₃]₂]₅, M[N[C₂H₅]₂]₅
- Imidoverbindungen:: z.B. [N[C₂H₅]₂]₃M=N^{t}Bu
mit M = Ta oder Nb

Sofern die Ausgangssubstanzen nicht gasförmig vorliegen, müssen diese in die Gasphase überführt werden. Für den Transport der Ausgangsverbindungen in den Reaktionsraum wird ein Trägergas verwendet. Als Trägergas kommen beispielsweise Stickstoff und Wasserstoff, sowie alle Edelgase in Betracht. Die Trägergase können auch Reaktionsgase sein, z.B. Stickstoff. Reiner Sauerstoff ist als Trägergas ungeeignet.

Im Reaktor wird ein Druck von ca. 0,1 bis < 50 mbar aufrechterhalten.

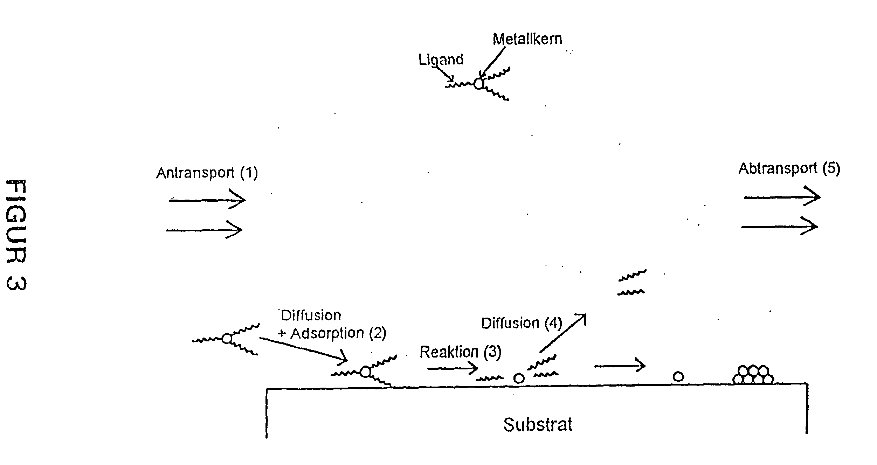

Das im Reaktor befindliche, zu beschichtende Kunststoffsubstrat wird in der Regel direkt beheizt. Die Temperatur sollte nicht mehr als 100°C betragen, da es sonst zu einer Schädigung des Kunststoffsubstrats kommen kann. Zusätzliche Energie wird durch die Einkoppelung des Plasmas zur Verfügung gestellt. Die im Gasraum befindlichen Ausgangssubstanzen gelangen an die Substratoberfläche und werden dort unter Zersetzung und Reaktion abgeschieden. Eine schematische Darstellung des Verfahrens ist der Figur 3 zu entnehmen. Zunächst erfolgt der Antransport (1) der Ausgangssubstanzen mit Hilfe eines Trägergases. Durch Diffusion und Adsorption (2) gelangt die Ausgangssubstanz an die Substratoberfläche, wo eine Reaktion (3) der Ausgangssubstanzen stattfindet. Flüchtige abgespaltene Reste werden durch Diffusion (4) wieder in die Gasphase zurückgeführt und dann erfolgt der Abtransport (5). Das metallhaltige Reaktionsprodukt wird dagegen auf der Oberfläche des Substrats abgeschieden.

Zunächst ist die Wirkung des eingekoppelten Plasmas gering, und die zunächst auf der Substratoberfläche abgeschiedene Substanz enthält noch beträchtliche Mengen an Kohlenstoff. Diese Verbindungen haben eine hohe Affinität zur Oberfläche des Kunststoffsubstrats und können in dieses zum Teil eindiffundieren, wodurch es zu einer starken Haftung kommt. Mit zunehmender Beschichtung des Substrats erhöht sich die Wirkung des Plasmas, es steht mehr Energie zur Verfügung, und die Umsetzungsreaktionen der Ausgangssubstanzen verlaufen immer vollständiger, d.h. es wird immer weniger Kohlenstoff, dafür aber prozentual mehr Metall in die Schicht eingebaut.

Dies führt letztlich dazu, daß durch den hohen Kohlenstoffgehalt der anfänglich abgeschiedenen Schicht eine innige fest haftende Verbindung zwischen der Kunststoffsubstratoberfläche und der metallhaltigen Schicht entsteht.

Bei einer Schichtdicke von ca. 20 nm ist die endgültige Zusammensetzung der metallhaltigen Schicht erreicht. Bei zunehmender Schichtdicke ändert sich die Zusammensetzung nicht mehr. Erst nach dem Abbruch des Beschichtungsverfahrens kommt es noch zu einer geringfügigen Änderung der Zusammensetzung in dem äußersten Teil der metallhaltigen Schicht, wie die Figuren 1 und 2 zeigen.

Das nachfolgende Schema zeigt die stufenweise zunehmende Reaktion am Beispiel der Ausgangsverbindung Ti[N(CH₃)₂]₄ in Abhängingkeit zunehmend vorhandener Energie für die Reaktion:

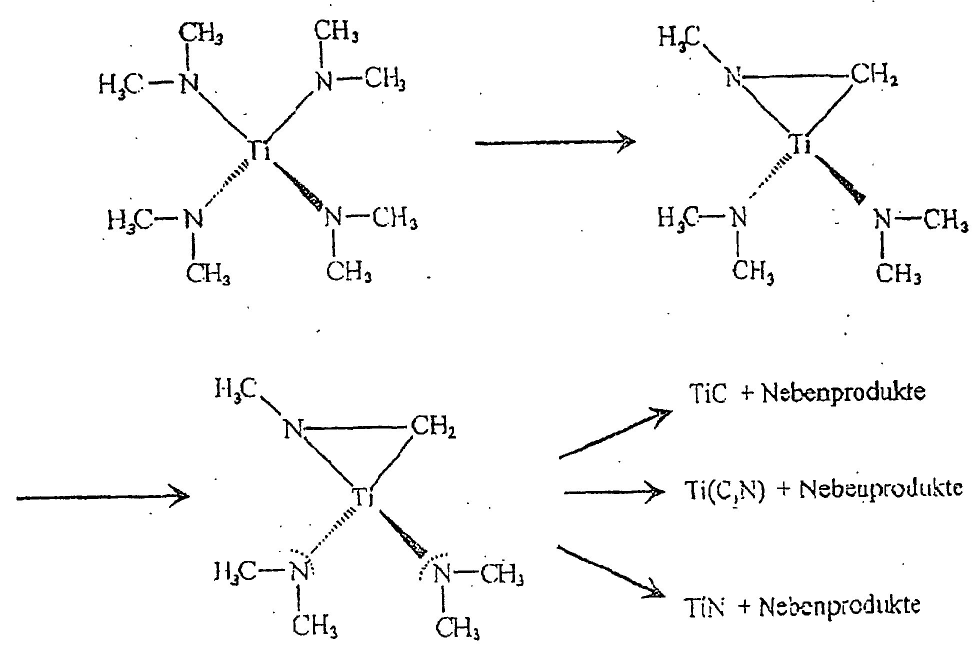

Wie der Figur 1 zu entnehmen ist, besteht die metallhaltige Schicht in einer Schichttiefe von ca. 2 nm, was zeitlich dem Abbrechen der Beschichtungsreaktion entspricht, aus ca. 40 Atom-% Ti, 35 Atom-% C, 15 Atom-% N und 10 Atom-% O. Eine solche Zusammensetzung weist eine außerordentlich günstige Verträglichkeit mit Blut auf, so daß sich derartige beschichtete Kunststoffsubstrate hervorragend zur Herstellung von künstlichen Gefäßimplantaten eignen.

Bei dem erfindungsgemäßen Verfahren ist es erstmalig gelungen, die Beschichtungstemperaturen auf ca. 100°C abzusenken und somit die erforderlichen Temperaturen einzuhalten, bei denen das Kunststoffsubstrat nicht geschädigt wird. Insbesondere bei Verwendung von Wasserstoff als Trägergas sind sehr niedrige Beschichtungstemperaturen möglich.

Wie in der Figur 2 gezeigt, nimmt die Oberfläche der metallhaltigen Schicht im Laufe der Zeit Sauerstoff auf. Wenn dies vermieden werden soll, eignet sich eine Nachbehandlung im Stickstoffplasma. Diese führt zu einer deutlichen Erhöhung des Stickstoffgehaltes der Oberfläche der metallhaltigen Schicht, und es kommt dadurch zu einer erheblichen Reduzierung der nachträglichen Sauerstoffaufnahme.

Durch das erfindungsgemäße Verfahren ist eine Beschichtung von Kunststoffsubstraten mit komplizierten Geometrien möglich, da die Ausgangssubstanz vor der Reaktion gleichmäßig mit dem zu beschichtenden Substrat in Kontakt kommt. Die Konzentration der Ausgangsverbindung ist dabei im Reaktionsraum relativ niedrig, um ein möglichst frühes Zusammenwachsen der Schichten und somit eine möglichst geringe Schichtdicke zu erreichen. Dies führt zu einer extrem glatten Oberfläche der Schicht, wodurch die hervorragende Verträglichkeit gegenüber Körperflüssigkeiten, wie z.B. Blut, gewährleistet wird.

Durch die Erfindung können bioverträgliche Oberflächen mit einer sehr guten elektrischen Leitfähigkeit auf ansonsten nicht leitenden Kunststoffen erzeugt werden, wodurch eine Vielzahl von neuen Anwendungsgebieten in der Medizintechnik erschlossen wird.

### Beispiel

Zunächst wurde das zu beschichtende Kunststoffsubstrat an seiner Oberfläche in einem Niederdruckplasma gereinigt. Dazu wurde Stickstoff mit einer Geschwindigkeit von ca. 5 l/h i.N. in den Reaktor eingeleitet, wobei mittels einer Vakuumpumpe im Reaktor ein Druck von ca. 1 mbar aufrechterhalten wurde. Durch einen außen liegenden Kupferring wurde mit 50 W ein induktives Plasma mit einer Frequenz von 13,56 MHz eingekoppelt. Die Behandlungsdauer betrug ca. 3 min (sie kann bei Bedarf abgekürzt werden).

Als flüssige organometallische Ausgangsverbindung wurde Ti[N(CH₃)₂]₄ eingesetzt. Die Ausgangsverbindung wurde bei 5°C mit reinem Wasserstoff durchströmt. Durch die Kühlung des Verdampfers wird eine zu hohe Konzentration der Ausgangssubstanz im Reaktionsraum und damit ein ungleichmäßiger Schichtaufbau vermieden.

Der mit der Ausgangssubstanz beladene Wasserstoff strömt in den Reaktor, in welchem sich das auf ca. 100°C aufgeheizte, im Niederdruckplasma vorbehandelte Kunststoffsubstrat (PET) befindet. Die Reaktion der Ausgangsverbindung wird durch zusätzliche Energiezufuhr, nämlich durch Einkoppeln eines Niederdruckplasmas ausgelöst. Das Plasma wird bei einem Druck im Reaktionsraum von ca. 1 mbar mittels des außen liegenden Kupferrings bei einer Frequenz von 13,56 MHz induktiv eingekoppelt. Dadurch wird das Gas im Bereich des Substrats teilweise ionisiert bzw. es kommt zu einer Radikalbildung. Entscheidend ist dabei, daß durch den reduzierten Druck im Gasraum die Gastemperatur selbst nur unwesentlich erhöht wird, jedoch Teilchen im Gas enthalten sind, die extrem energiereich sind und somit die Reaktion bei Temperaturen in Gang gesetzt werden kann, die erheblich reduziert sind.

Zunächst kommt es nur zu einer teilweisen Reaktion der Ausgangssubstanz und der anfängliche Schichtaufbau besteht aus einer metallhaltigen Verbindung, die noch sehr reich an Kohlenstoff ist, während die anderen Bestandteile, wie das Metall und der Stickstoff, nur in geringen prozentualen Anteilen vorhanden sind. Dies führt zu einer besonders guten Haftung an dem Kunststoffsubstrat, die durch eine Diffusion der anfänglich abgeschiedenen Teilchen in den Kunststoff noch verstärkt wird.

Durch den beginnenden Aufbau der metallhaltigen Schicht verändern sich die Oberflächeneigenschaften des Substrats und die Wirkung des eingekoppelten Plasmas auf das nun schon teilweise beschichtete Substrat nimmt zu. Durch die zunehmend günstigeren Energieverhältnisse kommt es zu weitergehenden Reaktionen der Ausgangsverbindungen, d.h., die Zusammensetzung der abgeschiedenen Schichten verändert sich im Laufe der Zeit, wobei der Kohlenstoffgehalt stetig abnimmt, während der Gehalt an Stickstoff und Metall zunimmt.

Der Beschichtungsvorgang wurde bei einer Schichtdicke von ca. 10 nm abgebrochen. Die Figur 1 zeigt in einer Schichttiefe von ca. 2 nm eine Zusammensetzung, die aus ca. 40 Atom-% Ti, 35 Atom-% C, 15 Atom-% N und 10 Atom-% O besteht. Diese Schichtzusammensetzung entspricht zeitlich dem Abbruch des Beschichtungsverfahrens. Im Abklingen der Reaktion ändert sich die Zusammensetzung wiederum ein wenig, wie der Figur 1 ebenfalls zu entnehmen ist.

Der erhaltene Verbundwerkstoff wurde mit XPS (X-ray photo-electron spectroscopy) auf seine Schichtzusammensetzung hin untersucht. Die Tiefenprofile wurden durch Absputtern der Schichten mit Ar⁺ aufgenommen. Das Ergebnis ist in Figur 1 gezeigt.

Eine erneute Untersuchung der Schichtzusammensetzung nach Lagerung des Verbundwerkstoffes an Luft ergab nach 2 Wochen eine Zusammensetzung, die der Figur 2 entspricht. Der Kohlenstoffgehalt und auch der Sauerstoffgehalt hatten aufgrund von Sauerstoffaufnahme und Oberflächenverunreinigungen zugenommen.

Eine Messung der Leitfähigkeit der Schichten ergab unmittelbar nach der Beschichtung einen Wert von L = 2,1 (Ohm·cm)⁻¹ und nach 3-tägiger Lagerung an Luft einen Wert von L = 0,18 (Ohm·cm)⁻¹.

Weiterhin wurde die Zughaftfestigkeit der metallhaltigen Schicht am Kunststoffsubstrat gemessen. Es wurden Werte von > 6 N/mm² gemessen. Das heißt, daß beim Abzugsversuch der Kleber versagte, während die metallhaltige Schicht am Kunststoffsubstrat haften blieb.

Schließlich wurden gemäß dem Verfahren, das in dem oben erwähnten Artikel von Dion et al. beschrieben ist, Rauhigkeitsmessungen der metallhaltigen Schichten durchgeführt. Es ergab sich der Wert von Rₐ = 0,001 µm.

## Patentansprüche

1. Verbundwerkstoff, bestehend aus einem Kunststoffsubstrat und einer dünnen geschlossenen metallhaltigen Schicht, **dadurch gekennzeichnet, daß** die metallhaltige Schicht duktil ist, fest auf dem Kunststoffsubstrat haftet, eine Dicke von < 2 µm aufweist und aus einer Verbindung der Formel
MₐO_{b}CₓN_{y}B_{z}
besteht, in welcher bedeuten:
M ein oder mehrere Metalle aus der Gruppe Ti, Ta, Nb, Zr und Hf,
a = 0,025 bis 0,9
b = 0,025 bis 0,7
x = 0,2 bis 0,9
y = 0 bis 0,7
z = 0 bis 0,7
a + b + x + y + z = 1,
mit der Maßgabe, daß der Wert von a von der Substratoberfläche ausgehend von einem Wert nahe Null zur Schichtoberfläche hin zunimmt und die Kohlenstoffatome an der Basis der Schicht zu mindestens 50 % an anderen Kohlenstoffatomen durch C-C-Bindungen gebunden sind.

2. Verbundwerkstoff nach Anspruch 1, **dadurch gekennzeichnet, daß** das Kunststoffsubstrat aus Polyethylenterephthalat, Polyurethan, Polytetrafluorethylen, Polyamid oder Polypropylen besteht.

3. Verbundwerkstoff nach den Ansprüchen 1 oder 2, **dadurch gekennzeichnet, daß** M = Ti ist.

4. Verbundwerkstoff nach den Ansprüchen 1 bis 3, **dadurch gekennzeichnet, daß** für die Werte von a, b, x, y und z folgendes gilt:
(i) an der Basis der metallhaltigen Schicht:
a = 0,025 - 0,1
b = 0,025 - 0,2
x = 0,8 - 0,9
y = 0 - 0,1
z = 0 - 0,1
(ii) mit zunehmender Dicke der metallhaltigen Schicht wird der Wert von a größer, und
(iii) nahe der Oberfläche der metallhaltigen Schicht:
a = 0,2 - 0,9
b = 0,025 - 0,7
x = 0 - 0,7
y = 0 - 0,7
z = 0 - 0,5.

5. Verbundwerkstoff nach den Ansprüchen 1 bis 4, dessen Schicht zusätzlich Wasserstoff enthält.

6. Verfahren zur Herstellung eines Verbundwerkstoffes nach den Ansprüchen 1 bis 5, **dadurch gekennzeichnet, daß** man
a) das Kunststoffsubstrat reinigt,
b) eine geeignete metallorganische oder organometallische Ausgangsverbindung auswählt,
c) die metallorganische oder organometallische Ausgangsverbindung, sofern sie nicht gasförmig ist, in die Gasphase überführt,
d) die gasförmige metallorganische oder organometallische Verbindung Ausgangsverbindung mit Hilfe eines Trägergases in einen Reaktor befördert, in welchem sich das Kunststoffsubstrat befindet, auf dessen Oberfläche die Ausgangsverbindungen durch chemische Gasphasenabscheidung unter Zersetzung und Reaktion abgeschieden werden, wobei
e) dem Substrat durch Plasmaeinkoppelung und gegebenenfalls direkte Beheizung Energie so zuführt, daß eine Temperatur von 100°C nicht überschritten wird, wobei durch die Wirkung des Plasmas ein Kohlenstoffund Metallgradient in Richtung der Schichtdicke erzielt wird,
f) im Reaktionsraum einen Druck von 0,1 bis < 50 mbar aufrechterhält, und
g) den Verbundstoff anschließend an Luft lagert.

7. Verfahren nach Anspruch 6, **dadurch gekennzeichnet, daß** als Trägergas Wasserstoff verwendet wird.

8. Verfahren nach den Ansprüchen 6 oder 7, **dadurch gekennzeichnet, daß** als metallorganische oder organometallische Verbindung
M[N[CH₃]₂]₄, M[N[C₂H₅]₂]₄, M[N(CH₂)(C[CH₃]₂)]₄, ((N^{t}Bu)M[N(CH₃)₂]₂)₂, ((N^{t}Bu)M[N(C₂H₅)₂]₂)₂,
M(CH₂^{t}Bu)₄ und/oder (C₅H₅)₂MCl₂
eingesetzt wird, wobei M = Ti, Zr oder Hf.

9. Verfahren nach Anspruch 8, **dadurch gekennzeichnet, daß** als metallorganische oder organometallische Verbindung Ti[N(CH₃)₂]₄ eingesetzt wird.

10. Verfahren nach den Ansprüchen 6 oder 7, **dadurch gekennzeichnet, daß** als metallorganische oder organometallische Verbindung M[N[CH₃]₂]₅, M[N[C₂H₅]₂]₅ und/oder [N[C₂H₅]₂]₃M=N^{t}Bu eingesetzt wird, wobei M = Ta oder Nb.

## Claims

1. Composite composed of a plastic substrate and a thin, continuous metal-containing layer, **characterized in that** the metal-containing layer is ductile, adheres firmly to the plastic substrate, has a thickness of < 2 µm and is composed of a compound corresponding to the formula
MₐO_{b}CₓN_{y}B_{z}
wherein:
M is one or more metals of the group Ti, Ta, Nb, Zr and Hf,
a = 0.025 to 0.9
b = 0.025 to 0.7
x = 0.2 to 0.9
y = 0 to 0.7
z = 0 to 0.7
a+b+x+y+z = 1
provided that the value of a, starting from the substrate surface, increases from a value approximating zero towards the layer surface, and at least 50 % of the carbon atoms at the base of the layer are bound to other carbon atoms by C-C bonds.

2. Composite according to claim 1, **characterized in that** the plastic substrate is composed of polyethylene terephthalate, polyurethane, polytetrafluoroethylene, polyamide or polypropylene.

3. Composite according to claims 1 or 2, **characterized in that** M = Ti.

4. Composite according to claims 1 to 3, **characterized in that** the following applies to the values of a, b, x, y and z:
(i) at the base of the metal-containing layer:
a = 0.025 - 0.1
b = 0.025 - 0.2
x = 0.8 - 0.9
y = 0 - 0.1
z = 0 - 0.1
(ii) as the thickness of the metal-containing layer increases, the value of a increases, and
(iii) near the surface of the metal-containing layer:
a = 0.2 - 0.9
b = 0.025 - 0.7
x = 0 - 0.7
y = 0 - 0.7
z = 0 - 0.5.

5. Composite according to claims 1 to 4, the coating of which additionally contains hydrogen.

6. Process for the production of a composite according to claims 1 to 5, **characterized in that**
a) the plastic substrate is cleaned,
b) a suitable metallo-organic or organometallic starting compound is selected,
c) the metallo-organic or organometallic starting compound, if it is not gaseous, is converted to the gas phase,
d) the gaseous metallo-organic or organometallic compound starting compound is conveyed by means of a carrier gas to a reactor in which is situated the plastic substrate, on the surface of which the starting compounds are deposited by chemical vapour deposition accompanied by decomposition and reaction,
e) energy is passed to the substrate by plasma coupling and optionally direct heating so that a temperature of 100°C is not exceeded, a carbon and metal gradient in the direction of the layer thickness being achieved by the action of the plasma,
f) a pressure of 0.1 to < 50 mbar is maintained in the reaction chamber, and
g) the composite is then stored in air.

7. Process according to claim 6, **characterized in that** hydrogen is used as carrier gas.

8. Process according to claim 6 or 7, **characterized in that** the metallo-organic or organometallic compound used is
M[N[CH₃]₂]₄, M[N[C₂H₅]₂]₄, M[N(CH₂)(C[CH₃]₂)]₄,
((N^{t}Bu)M[N(CH₃)₂]₂)₂, ((N^{t}Bu)M[N(C₂H₅)₂]₂)₂,
M(CH₂^{t}Bu)₄ and/or (C₅H₅)₂MCl₂
where M = Ti, Zr or Hf.

9. Process according to claim 8, **characterized in that** the metallo-organic or organometallic compound used is Ti[N(CH₃)₂]₄.

10. Process according to claims 6 or 7, **characterized in that** the metallo-organic or organometallic compound used is M[N[CH₃)₂]₅, M[N[C₂H₅]₂]₅, and/or [N[C₂H₅]₂]₃M=N^{t}Bu where M = Ta or Nb.

## Revendications

1. Matériau composite constitué d'un substrat en matière plastique et d'une couche métallique mince fermée,
**caractérisé en ce que** la couche métallique est ductile, adhère solidement au substrat en matière plastique, présente une épaisseur < 2 µm et est formée d'un composé de formule
MₐO_{b}CₓN_{y}B_{z}
dans laquelle :
M signifie un ou plusieurs métaux du groupe formé formé de Ti, Ta, Nb, Zr et Hf,
a = 0,025 à 0,9
b = 0,025 à 0,7
x = 0,2 à 0,9
y = 0 à 0,7
z = 0 à 0,7
a + b + x + y + z = 1,
avec la condition que la valeur de a, partant d'une valeur proche de zéro à la surface du substrat, augmente vers la surface de la couche, et qu'au moins 50 % des atomes de carbone à la base de la couche soient liés à d'autres atomes de carbone au moyen de liaisons C-C.

2. Matériau composite selon la revendication 1, **caractérisé en ce que** le substrat en matière plastique est formé de téréphtalate de polyéthylène, de polyuréthanne, de polytétrafluoroéthylène, de polyamide ou de polypropylène.

3. Matériau composite selon la revendication 1 ou 2, **caractérisé en ce que** M = Ti.

4. Matériau composite selon les revendications 1 à 3, **caractérisé en ce que** ce qui suit s'applique aux valeurs de a, b, x, y et z :
(i) à la base de la couche métallique :
a = 0,025 - 0,1
b = 0,025 - 0,2
x = 0,8 - 0,9
y = 0 - 0,1
z = 0 - 0,1
(ii) la valeur de a augmente quand l'épaisseur de la couche métallique augmente, et
(iii) à proximité de la surface de la couche métallique :
a = 0,2 - 0,9
b = 0,025 - 0,7
x = 0 - 0,7
y = 0 - 0,7
z = 0 - 0,5.

5. Matériau composite selon les revendications 1 à 4, dont la couche contient, en outre, de l'hydrogène.

6. Procédé de fabrication d'un matériau composite selon les revendications 1 à 5, **caractérisé en ce que** :
a) on nettoie le substrat en matière plastique,
b) on choisit un composé de départ métallo-organique ou organométallique approprié,
c) on amène le composé de départ métallo-organique ou organométallique en phase gazeuse s'il n'est pas à l'état gazeux,
d) on transporte le composé métallo-organique ou organométallique gazeux, en tant que composé de départ, à l'aide d'un gaz porteur, dans un réacteur dans lequel se trouve le substrat en matière plastique, à la surface duquel les composés de départ se déposent par dépôt chimique en phase gazeuse avec décomposition et réaction,
e) de l'énergie étant amenée au substrat par injection de plasma et, le cas échéant, par chauffage direct, de façon à ce qu'une température de 100°C ne soit pas dépassée, l'effet du plasma permettant d'obtenir un gradient de carbone et de métal dans la direction de l'épaisseur de la couche,
f) dans l'espace de réaction, on maintient une pression de 0,1 à < 50 mbar,
et
g) ensuite, on stocke le matériau composite à l'air.

7. Procédé selon la revendication 6, **caractérisé en ce qu'**on utilise de l'hydrogène comme gaz porteur.

8. Procédé selon la revendication 6 ou 7, **caractérisé en ce qu'**on utilise, comme composé métallo-organique ou organométallique,
M[N[CH₃]₂]₄, M[N[C₂H₅]₂]₄, M[N(CH₂)(C[CH₃]₂)]₄,
((N^{t}Bu)M[N(CH₃)₂]₂)₂, ((N^{t}Bu)M[N(C₂H₅)₂]₂)₂,
M(CH₂^{t}Bu)₄ et/ou (C₅H₅)₂MCl₂,
où M = Ti, Zr ou Hf.

9. Procédé selon la revendication 8, **caractérisé en qu'**on utilise du Ti[N(CH₃)₂]₄ comme composé métallo-organique ou organométallique.

10. Procédé selon la revendication 6 ou 7, **caractérisé en ce qu'**on utilise du M[N[CH₃]₂]₅, du M[N[C₂H₅)₂]₅ et/ou du [N[C₂H₅]₂]₃M=N^{t}Bu, où M = Ta ou Nb, comme composé métallo-organique ou organométallique.
